# EUROPEAN PATENT APPLICATION

(11) **EP 4 400 852 A1**
(43) Date of publication of application: **17.07.2024**
(21) Application number: 23151599.0
(22) Date of filing: 13.01.2023
(51) Int. Cl.: G01R 31/367, G01R 31/392, B60L 3/12

(54) **BATTERY CONDITION MONITORING**

(71) Applicant: TWAICE Technologies GmbH, 80807 München (DE)
(72) Inventor: WILDFEUER, Leo, 80336 München (DE); MEIßNER, Michael, 82110 Germering (DE); BERG, Philipp, 81827 München (DE); KARGER, Alexander, 81667 München (DE)
(74) Representative: Kraus & Lederer PartGmbB

(57) **Abstract**

Various examples of the disclosure pertain to monitoring a condition of a battery. Individual cells of small groups of cells are monitored. Problematic behavior or anomalous behavior of individual cells of small groups of cells can be detected. Reporting of measurement observables by a battery management system can be reconfigured and adjusted.

## Description

### TECHNICAL FIELD

Various examples of the disclosure generally pertain to condition monitoring of batteries. Various examples of the disclosure specifically relate to assessing a cell state of multiple cells of a battery based on reporting from a battery management system.

### BACKGROUND

Rechargeable batteries are employed in various use cases. For instance, energy storage systems (ESSs) can be employed to store excess electrical power in the power grid during time periods of high power generation and low consumption. When power generation - e.g., by renewable sources - is low, but public demand is high, ESSs can output previously stored electrical power to the grid. On a smaller level, batteries can be used to buffer locally generated electrical power for households or buildings, e.g., hospitals, residential homes, etc.. Rechargeable batteries are also employed for powering electrical vehicles.

Condition monitoring for batteries helps to identify various state parameters of batteries, e.g., state of health.

### SUMMARY

A need exists for advanced techniques of condition monitoring for batteries. A need exists for techniques that enable fine-grained and high-resolution condition monitoring.

This need is met by the features of the independent claims. The features of the dependent claims define embodiments.

According to the techniques disclosed herein, a cell state of battery cells of a battery can be assessed. A problematic behavior or fault state of individual cells or small groups of cells can be detected. Thereby, root causes of failures of a battery can be tracked down to cell level.

A computer-implemented method is disclosed. The method includes obtaining a stream of data packets. The stream is obtained from a battery management system of a battery. The battery includes a plurality of cell reporting groups. Each data packet of the stream of data packets is associated with a subset of the cell reporting groups of the plurality of cell reporting groups. Each cell reporting group includes one or more battery cells of the battery. Each data packet includes values of at least one measurement observable for each cell reporting group of the respective subset and a respective sampling time. The method also includes analyzing the stream of data packets to determine, for each one of the one or more cell reporting groups of the plurality of cell reporting groups, respective group-specific aggregated information across multiple sampling times. This is based on the values of the at least one measurement observable provided for the respective cell reporting group. Also, the method includes for each one of the one or more cell reporting groups of the plurality of cell reporting groups: assessing a cell state of the respective one or more battery cells included in the respective cell reporting group based on the respective group-specific aggregated information.

A computer program includes program code that can be loaded from a memory and executed by at least one processor. The at least one processor, upon executing the program code, performs a method as disclosed herein. The method includes obtaining a stream of data packets. The stream is obtained from a battery management system of a battery. The battery includes a plurality of cell reporting groups. Each data packet of the stream of data packets is associated with a subset of the cell reporting groups of the plurality of cell reporting groups. Each cell reporting group includes one or more battery cells of the battery. Each data packet includes values of at least one measurement observable for each cell reporting group of the respective subset and a respective sampling time. The method also includes analyzing the stream of data packets to determine, for each one of the one or more cell reporting groups of the plurality of cell reporting groups, respective group-specific aggregated information across multiple sampling times. This is based on the values of the at least one measurement observable provided for the respective cell reporting group. Also, the method includes for each one of the one or more cell reporting groups of the plurality of cell reporting groups: assessing a cell state of the respective one or more battery cells included in the respective cell reporting group based on the respective group-specific aggregated information.

A computing device - e.g., a cloud server or a personal computer - includes a processor and a memory. The processor can load program code from the memory and execute the program code. The processor, upon executing the program code, is configured to obtain a stream of data packets. The stream is obtained from a battery management system of a battery that includes multiple battery cells. Each battery cell is associated with one or more cell reporting groups. Each data packet of the stream of data packet is associated with a subset of the cell reporting groups of the plurality of cell reporting groups. Each data packet includes values of at least one measurement observable for each cell reporting group of the respective subset at a respective sampling time. The processor is configured to analyze the stream of data packets to determine, for each one of the one or more cell reporting groups of the plurality of cell reporting groups, respective group-specific aggregated information across multiple sampling types. This is based on the values of the at least one measurement observable provided for the respective cell reporting group. Also, the processor is configured, for each one of the one or more cell reporting groups, to assess a cell state of the respective one or more battery cells associated with the respective cell reporting group based on the respective group-specific aggregated information. It is to be understood that the features mentioned above and those yet to be explained below may be used not only in the respective combinations indicated, but also in other combinations or in isolation without departing from the scope of the invention.

### BRIEF DESCRIPTION OF THE DRAWINGS

FIG. 1A schematically illustrates a system including a central computing device and multiple batteries according to various examples.
FIG. 1B schematically illustrates cell reporting groups according to various examples.
FIG. 2 schematically illustrates a data stream including multiple data packets provided by a battery management system for reporting on values of one or more measurement observables according to various examples.
FIG. 3 schematically illustrates details of the data packets of the data stream of FIG. 2 according to various examples.
FIG. 4 schematically illustrates a distribution of voltage values over sampling times and over battery cells according to various examples.
FIG. 5 is a flowchart of a method according to various examples.
FIG. 6 is a processing pipeline for battery condition monitoring according to various examples.

### DETAILED DESCRIPTION

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired. It is recognized that any circuit or other electrical device disclosed herein may include any number of microcontrollers, a graphics processor unit (GPU), integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a program code that is embodied in a non-transitory computer readable medium programmed to perform any number of the functions as disclosed.

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

Various disclosed techniques pertain to condition monitoring for batteries. The batteries include multiple battery cells. Multiple cells can be connected in series and/or in parallel.

The batteries may be employed in ESSs, as traction batteries in vehicles, local power storage devices, etc..

According to various examples, cell states are assessed for the multiple cells. For example, for each cell or small groups of cells of the battery (e.g., including up to ten or twenty cells), a respective value of the cell state is determined. By determining the cell state on cell level for individual cells or small groups of cells - rather than only a battery-specific condition - more detailed information regarding the condition of the battery can be obtained. A problematic behavior can be tracked down to cell level. Root causes of battery faults can be detected.

According to various examples, the cell states are assessed centrally at a central computing device. The central computing device is located remote from the batteries so that the battery management systems of the batteries and the central computing device communicate via a bandwidth limited channel. Cloud condition monitoring is thereby enabled.

According to examples disclosed herein, the cell state is the state of health. For instance, a DC resistance/impedance can be determined on cell level. The DC resistance typically increases for progressed aging of a cell. Alternatively or additionally, the capacity can be determined as cell state. Typically, the capacity decreases for progressed aging of a cell.

Algorithms and models are available to quantify the cell state. To give an example, techniques are known to determine the state of health based on values for electrical current and voltage in a cell. For example, the DC resistance can be directly calculated from voltage and current. It would also be possible to predict ageing of a battery, e.g., using an electric-thermal co-simulation. The particular cell state that is assessed is not germane for the techniques disclosed herein and various prior art techniques can be employed.

Various techniques disclosed herein are concerned with collection of information based on which the cell state of a cell or of multiple cells of the battery can be assessed. Information for multiple cells of the battery is obtained from a battery management system of the battery. The battery management system accordingly provides a reporting functionality.

To determine the cell state for individual cells or small groups of cells, information obtained for so-called cell reporting groups can be processed.

Each battery cell of the battery is associated with one or more cell reporting groups. Each cell reporting group includes one or more batteries.

Measurement observables are available for each cell reporting group. Each cell reporting group is associated with a respective measurement observables or multiple measurement observables.

In other words, the cell reporting group can be associated with the cell-related granularity reporting provided by the battery management system. For instance, number of battery cells can be electrically connected in parallel, e.g., two to four battery cells. Then, since the same voltage is applied between anodes and cathodes of these battery cells connected in parallel, typically the battery cells connected in parallel form a single cell reporting group and only a single voltage value is reported. Similarly, oftentimes a number of battery cells is connected in series. Here, the same current flows through each one of the battery cells and these battery cells in series connection form a single cell reporting group for which only a single current value is reported.

As a general rule, a count of cells per cell reporting group can be between one and ten or between one and twenty.

As a general rule, different observables can be associated with different cell reporting groups. For instance, a given battery cell can be part of multiple cell reporting groups, e.g., can be part of a first cell reporting group for current reporting and a second cell reporting group for voltage reporting.

Different cell reporting groups can have different cell reporting group identities. These identities allow to distinguish between different cell reporting groups.

According to examples, the battery management system provides a stream of data packets, i.e., a temporal sequence of data packets. Each data packet of the stream of data packets is associated with a subset of the cell reporting groups of the battery (i.e., only a fraction of all cell reporting groups). In other words, the battery management system can repetitively transmit data packets, each data packet reporting on one or more cell reporting groups of the battery at a respective observation time (sampling time). Sometimes, information for multiple sampling times can be aggregated into a single data packet.

Each data packet includes values of one or more measurement observables for each cell reporting groups of the respective subset on which that data packet reports. For example, a first data packet can include a voltage values for cell reporting groups A and C of the battery; a subsequent, second data packet than can include voltage values for cell reporting groups A and B of the battery.

Other measurement observables are possible, e.g., current or temperature or pressure to give a few examples.

The stream of data packets is obtained at a central computing device, e.g., a server. The stream of data packets can be received via the Internet.

Then, the stream is analyzed. I.e., individual data packets are accessed and the information content is processed.

Since each data packet includes information on only the subset of the cell reporting groups, analyzing the stream can include determining aggregated information across multiple sampling times for each cell reporting groups. In other words, each time a data packet includes a value of the measurement observable for a given cell reporting groups, this value can be stored in association with that given cell reporting groups. Alternatively or additionally, it would also be possible to process each value of the measurement of observable directly and then store the processed information. Thus, the stream of data packets is analyzed to determine reporting-group-specific aggregated information across multiple sampling times for each cell reporting groups. In any case, a sorting of values of the one or more measurement observables amongst cell reporting groups is thereby achieved. Then, the cells states are assessed based on the aggregated information for each cell reporting groups. Cell states can be determined down the the granularity of association of battery cells with cell reporting groups.

In a concrete example, each data packet includes the minimum voltage across all cell reporting groups together with the cell reporting group identity of the cell reporting groups that observes the minimum voltage at the sampling time; each data packet also includes the maximum voltage across all cell reporting groups together with the cell reporting group identity of the respective cell reporting groups that observes the maximum voltage at the sampling time. I.e., for each sampling time - defined by the data packets of the stream of data packets -tuples of values (maximum voltage; cell reporting group number) and (minimum voltage; cell reporting group number) are available. It is then possible to calculate battery parameters for all individual cell reporting groups which represented the minimum or maximum voltage for any amount of time which is long enough to carry out the analysis needed to identify problematic behavior and hence making these individual cell reporting groups observable from only aggregated signals. Extending the approach, it is possible to take into account n max/min voltages with n>1 per data packet (e.g., the n-largest voltage values across all cell reporting groups) and their respective cell reporting group number (also referred to as group identity) in order to make more individual cell reporting groups observable per data packet. This means that with only four aggregated signals (min/max voltage + cell reporting group identity) for each data packet, parameters of many individual cell reporting groups can be tracked (by aggregating over time) and cells of individual cell reporting groups become observable. The number n can be set to obey a trade-off between the amount of data collected and the number of cell reporting groups that are observable. The number n can be defined by a variable setting of a reporting scheme of the battery management system.

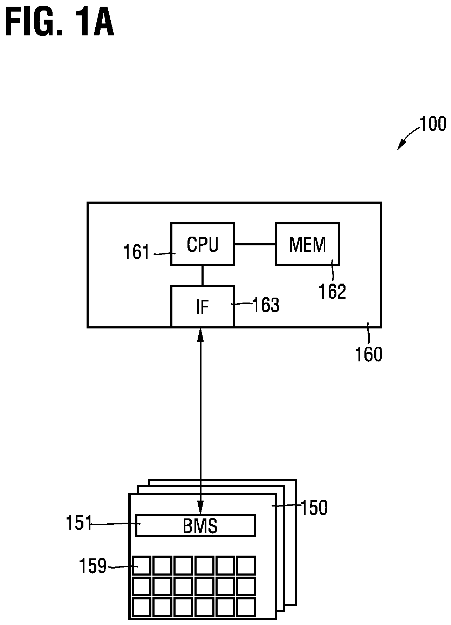

FIG. 1A schematically illustrates a system 100 including one or more batteries 150 and a central computing device 160, e.g., a server. The central computing device 160 includes a processor 161 and a memory 162. The central computing device 160 also includes a communication interface 163. The processor 161 can communicate with the battery management system 151 of each one of the batteries 150 via the communication interface 163. The communication between the central computing device 160 and the batteries 150 is via the Internet or another bandwidth-limited channel.

The battery management systems can proactively register at the repository that is accessible by the central computing device 160. Thereby, the central computing device 160 can keep track of all batteries that are currently operating. Reporting using the stream of data packets can be proactively triggered by the battery management systems 151 of the batteries 150.

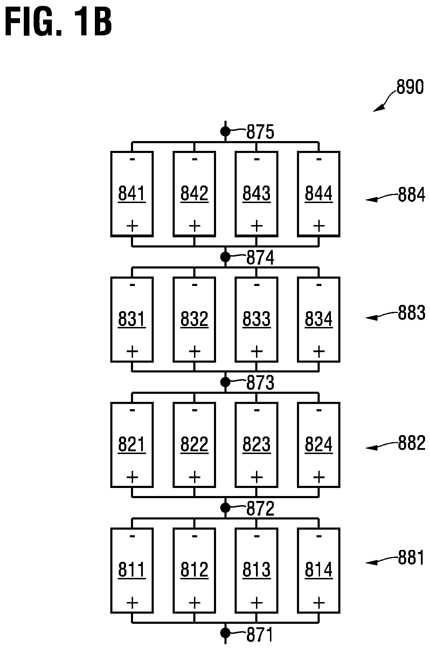

Each one of the batteries 150 includes multiple cells 159 and a battery management system 151. The battery management system 151 reports values of one or more measurement observables - e.g., voltage and/or current and/or temperature and/or pressure - using a stream of data packets that is transmitted to the central computing device 160. A data connection can be established between the central computing device 160 and each one of the batteries 150. The data connection can pertain to a fixed end-to-end logical channel, e.g., implemented as a TCP tunnel, a Layer 2 tunnel, an application layer end-to-end connection, or the like. Then, the stream of data packets can be communicated via the data connection. For example, it is possible that each battery 150 registers at a repository maintained by the central computing device 160, responsive to a respective application executed by the battery management system 151 obtaining access to the Internet. The battery management system 151 can indicate its type and/or the type of the battery 150. The battery management system 151 can provide other type information regarding the battery 150, e.g., the number of cells, the number of cell reporting groups, the cell reporting group identity of each one the cell reporting groups, the type of each cell reporting group, a measurement observable associated with each cell reporting group (e.g., temperature or voltage or current or pressure, etc.) ,a type of the battery management system, a reporting capability of the battery management system (e.g., indicating supported settings of a reporting scheme for providing the data stream), etc. By such techniques, condition monitoring can be facilitated for a large number of batteries. Defective cells can be detected. Problematic behavior can be resolved at cell reporting group granularity. Next, details with respect to a cell reporting group are discussed in connection with FIG. 1B.

FIG. 1B illustrates an electrical wiring of multiple cells 811-814, 821-824, 831-834, 841-844 of a battery. Illustrated is a so-called "4p5s" wiring, where four cells are connected in parallel and five cells are connected in series. This is only one example in other examples are possible.

Also illustrated is an association of the cells 811-814, 821-824, 831-834, 841-844 with cell reporting groups 881-884, 890. The cell reporting groups 881-884 for reporting voltage values. For instance, the voltage value between points 871 and 872 is reported by the cell reporting group 881; the voltage value between points 872 and 873 is reported by the cell reporting group 882; the voltage between points 873 and 874 is reported by the cell reporting group 883; and the voltage between points 874 and 875 is reported by the cell reporting group 884. The cell reporting group 890 is associated with reporting the current flowing at point 875 (or similar at any one of points 871-874).

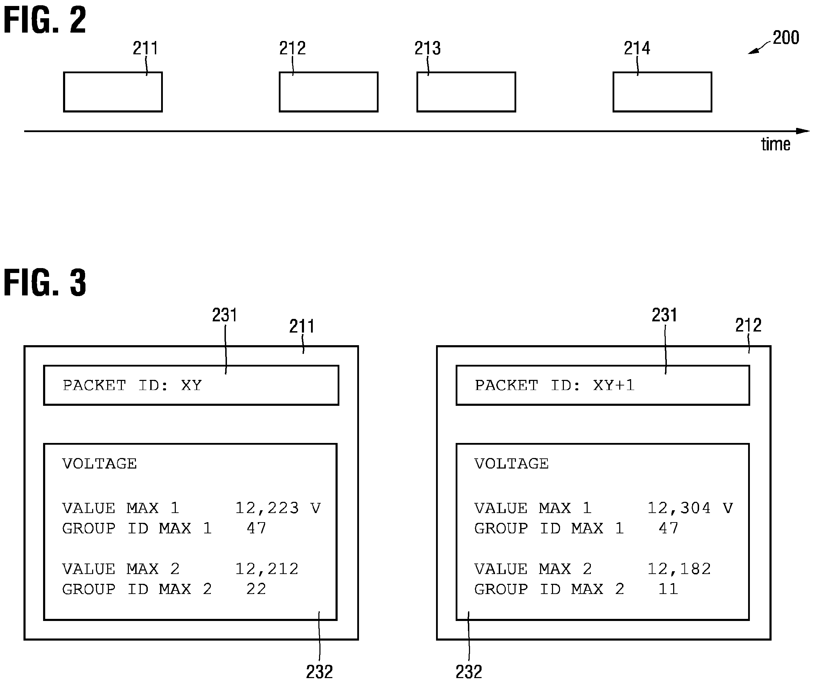

FIG. 2 schematically illustrates the stream 200 of data packets 211-214. Each one of the data packets 211-214 includes reporting for one more cell reporting groups. Typically, each data packet only reports on a subset of all available cell reporting groups (per observable).

In the scenario of FIG. 2, the data packets 211-214 are irregularly spaced in time; it would also be possible that the data packets 211-214 are regularly spaced in time, i.e., offset from each other at a fixed time interval. Such and other properties can be set by a reporting scheme that configures the reporting by the BMS 151.

The transmission timing of the data packets 211-214 can be indicative of a sampling time at which values of one or more measurement observables are acquired at the battery management system 151. In other examples, it would also be possible that the data packets include timestamps that are indicative of the sampling time; then, transmission timing and sampling time can be decoupled to some extent.

The reporting scheme, in some examples, defines a sampling offset between adjacent sampling times . This means that the distance between two sampling times for which a respective data packet is provided is defined by the reporting scheme. To give an example, sampling times could be offset in the range of one second to ten seconds from each other. In some scenarios, the respective setting of the reporting scheme defining the sampling offset is adjustable. Thereby, a temporal resolution with which the values of the measurement observable or measurement observables are obtained can be adjusted. This helps to adjust the temporal resolution with which the condition of the battery is monitored.

FIG. 3 schematically illustrates aspects with respect to the information content of the data packets 211, 212. The two data packets 211, 212 illustrated in FIG. 3 are used as examples of the information content for any one of the data packets of a respective stream 200 (cf. FIG. 2).

The data packets 211, 212 include a packet header 231. The packet header 231 can include one or more of the following: an identity or a sequence number of each data packet (this is illustrated in FIG. 3); an indication of a sampling time for which values of one or more measurement observables are provided in the body 232 of the data packets 211, 212; authentication credentials, e.g., a certificate of the battery management system providing the data packets 211, 212; an identity of the battery management system providing the data packets 211, 212; an identity of a data connection between the battery 150 and the central computing device 160 used for communicating the stream 200 including the data packets 211, 212; a current setting of the reporting scheme under which the respective data packets 211, 212 are provided; etc.

Next, details with respect to the body 232 of the data packets 211, 212 are explained. In the illustrated example, the body 232 includes voltage values for a subset of two cell reporting groups 159 of the battery 150. In particular, the two largest voltage values are reported and the respective cell reporting groupidentity (here, cell reporting group"47" and cell reporting group "22" for data packet 211; and cell reporting group "47" and cell reporting group "11" for data packet 212) is indicated.

The particular information content of the body 232 of the data packets 211, 212 is, in some examples, reconfigurable. In particular, a reporting scheme for providing the stream of data packets can be configured with a given setting, wherein the setting defines the information content.

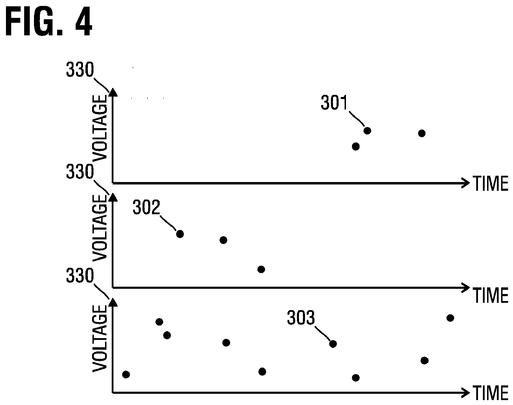

Next, some examples of aspects of the information content that can be changed by adjusting the setting of the reporting scheme are provided:
The setting can specify an integer number of *n_{max,V}* > 0 that defines that the *n_{max,V}*-largest voltage values observed across all cells to be reported (in FIG. 3, *n_{max,V}* = 2). The setting can specify an integer number of *n_{min,V}* > 0 that defines that the *n_{min,V}*-smallest voltage values observed across all cells to be reported. The setting can specify an integer number of *n_{max,I}* > 0 that defines that the *n_{max,I}*-largest current values observed across all cells to be reported. The setting can specify an integer number of *n_{min,I}* > 0 that defines that the *n_{min,I}*-smallest current values observed across all cells to be reported. The setting can specify integer number of *n_{max,T}* > 0 that defines that the *n_{max,T}*-largest temperature values observed across all cells to be reported. The setting can specify an integer number of *n_{min,T}* > 0 that defines that the *n_{min,T}*-smallest temperature values observed across all cell reporting groups to be reported; etc. Thus, each data packet 211, 212 includes values of one or more measurement observables - here, the voltage value - for only a subset of all cell reporting groups of the battery. Thus, as illustrated in FIG. 4, values 301 of the voltage 330 for a first cell reporting groupare available at different sampling times if compared to values 302, 303 of the voltage 330 for a second cell reporting group and a third cell reporting group, respectively.

Reporting such extreme values of measurement observables - as explained above - is an example implementation of information content to be included in the data packet in accordance with a respective setting of a reporting scheme. Alternatively or additionally, other information may be included. In an example, a data packet can be indicative of the value of a measurement observable of the particular cell reporting group that is closest to the median or average of the values of the measurement observable across all cell reporting groups at the sampling time. In an example, a data packet can be indicative of the median or average of the values of the measurement observable across all cell reporting groups at the sampling time. In an example, a data packet can be indicative of a width of a distribution of values of a measurement observable across all cell reporting groups at the sampling time. Such properties, in other words, describe the distribution of values of the respective measurement observable at a sampling time across all cell reporting groups. Such information can be helpful in order to identify whether the extreme values of the measurement observables are indicative of anomalous behavior, i.e., represent outliers outside of the distribution, or are rather within the expected variation of the distribution.

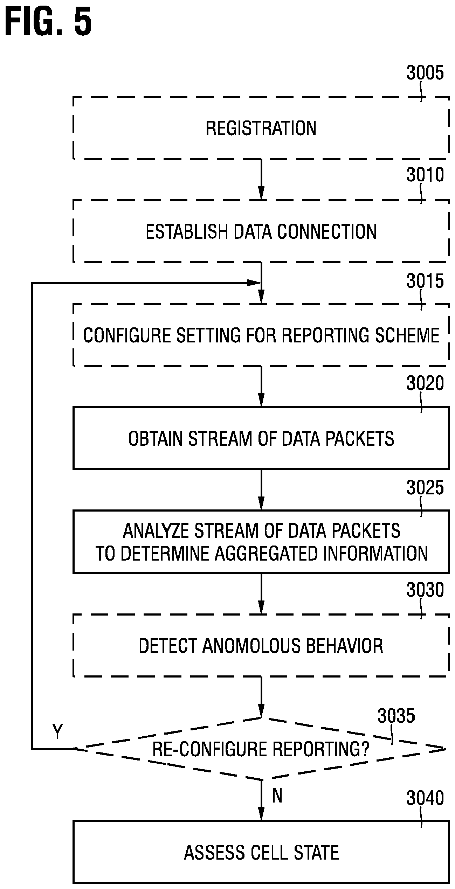

FIG. 5 is a flowchart of a method according to various examples. Optional boxes are depicted with dashed lines. The method of FIG. 5 is a computer-implemented method. The method of FIG. 5 can be executed by a computing device such as the central computing device 160 of FIG. 1A. The method of FIG. 5 can be executed by a processor upon loading and executing program code from a memory. For example, the method of FIG. 5 can be executed by the processor 161 upon loading program code from the memory 162 and upon executing the program code.

The method of FIG. 5 generally pertains to condition monitoring of a battery on cell reporting group level. The method of FIG. 5 pertains to assessing a cell state of cells of a battery. For this, reporting of a battery management system is monitored and analyzed.

At box 3005, a battery management system registers at a repository. For instance, the battery management system can execute an application and the application can be provided with connection details to contact the repository (e.g., a URL or an IP address). The registration can be responsive to the battery management system detecting access to the Internet. Cloud condition monitoring can thereby be enabled.

A registration is not required in all examples. In other examples, e.g., for a one-to-one communication, registration may not be necessary. Also, the central processing device could contact the battery management system. As such, box 3005 is optional.

Then, at box 3010, a data connection is established between the battery management system and the computing device. The data connection is typically via the Internet. The data connection is used to deliver a stream of data packets.

Establishment of a data connection is not required in all scenarios. For instance, other reporting schemes not employing a data connection are conceivable, e.g., via text messages, email, etc. Accordingly, box 3010 is optional

At box 3015, a setting for reporting scheme that defines how the battery management system reports on one or more measurement observables is optionally configured (in other examples, the setting can be fixed, e.g., depending on a capability of the BMS). The reporting scheme is used to provide a stream of data packets via the data connection. Each data packet includes one or more values of one or more measurement observables for one or more cell reporting groups of the battery.

For example, the reporting scheme can define the information content of the data packets.

The reporting scheme can define which one or more measurement observables are to be reported (e.g., voltage or current or both). Cell reporting groups associated with a non-reported measurement observable can be deactivated.

For instance, the reporting scheme can define how many of the largest voltage and/or current and/or temperature values across the respective cell reporting groups of the battery are to be included in the respective data packet.

The reporting scheme could also define that - at least for a certain time duration - voltage and/or current and/or temperature values are to be reported for all cells of the battery.

The reporting scheme could also define a round-robin scheme for including one or more values of one or more measurement observables for different cell reporting groups in the data packets (e.g., reporting the voltage of cell reporting group A in a first packet, then reporting the voltage of cell reporting group B in a second packet, the reporting the voltage of cell reporting group C in a third packet, then reporting again the voltage of cell reporting group A in a fourth packet, then reporting again the voltage of cell reporting group B in a fifth packet, and so forth). For instance, when reporting in accordance with a predefined round-robin scheme, it may be dispensable to include the cell reporting groupidentity of cell reporting groups in associated with a given data packet in the data packets, because the cell reporting groupidentity is predetermined based on the round-robin scheme.

The reporting scheme can also specify whether event-triggered reporting or repetitive reporting of the data packets is to be used. For instance, for repetitive reporting sampling times can be repetitively arranged in time domain and for each sampling time a respective data packet may be provided. Differently, for event-triggered reporting, the battery management system locally monitors the values of one or more measurement observables and, responsive to the values of one or more measurement observables fulfilling one or more predetermined criteria for at least one cell reporting group, provides a respective data packet that reports on the one or more measurement observables fulfilling the one or more predetermined criteria for the at least one cell reporting group. Example predetermined criteria that trigger the event-triggered reporting could be a value of a measurement observable (e.g., voltage or current or temperature) exceeding or falling below a certain predetermined threshold, e.g., for a certain time duration for a given cell reporting group. Also, beyond such absolute definitions of a predetermined criterion, relative predetermined criteria are conceivable; an example of a relative predetermined criterion would be a spread of values of a measurement values between pairs of cell reporting groups exceeding a certain predetermined threshold for a certain duration. I.e., a data packet can be provided if a difference between voltage values for at least two cell reporting groups exceeds a threshold.

By appropriately configuring the reporting scheme at box 3015, tailored reporting is possible. In particular, a trade-off scenario between excessive data being reported to the central computing device from the battery management system on the one hand, and too little information being reported to be able to implement accurate condition monitoring can be addressed. Typically, as has been explained in connection with FIG. 1A, condition monitoring can be employed for a large number of batteries. Since each battery also includes a large number of cells, data at the central computing device would quickly accumulate if each battery management system was to report extensive information for each cell at frequent sampling times. Rather, by reporting extreme values and/or event-triggered reporting, the amount of data to be reported can be significantly reduced - while still maintaining the ability for accurate condition monitoring (e.g., responsive to detecting an anomaly).

According to examples, the reporting scheme can be configured depending on the type of the battery management system. For example, a capability of the battery management system to provide the reporting in accordance with certain settings can be considered. Accordingly, it is helpful of the battery management system registers at the repository and indicates its type. Thereby, tailored reporting can be enabled for a wide range of battery management systems, e.g., from different manufacturers.

At box 3020, the stream of data packets is obtained. The stream of data packets is provided by the battery management system. The stream of data packets is provided in accordance with the current setting of the reporting scheme, as set in the preceding iteration of box 3015. Box 3020 can include receiving the data packets via the Internet. Box 3020 can include receiving the data packets via a data connection that has been established at box 3010.

Each data packet of the stream includes values of at least one measurement observable for each cell reporting groupof a respective subset and at a respective sampling time. For instance, each data packet could include the maximum voltage value taken across all voltage-reporting cell reporting groups of the battery at a respective sampling time. The information content is defined by the current setting of the reporting scheme, as discussed above.

At box 3025, the stream of data packets is analyzed to determine, for each one of one or more cell reporting groups of the plurality of cell reporting groups of the battery, respective group-specific aggregated information across multiple sampling times. This is based on the values of the at least one measurement observable. The aggregated information is determined for each of multiple cell reporting groups (not necessarily for all cell reporting group of the battery or even not for all cell reporting groups that are associated with the same measurement observable). For instance, as has been explained above in connection with FIG. 4, the reported voltage values can be sorted depending on a cell reporting groupidentity. The cell reporting groupidentity can be explicitly included in the data packet (cf. FIG. 3) or could be derivable from the reporting scheme and the position of each data packet in the sequence.

For instance, for each cell reporting group of the battery a respective group-specific data structure or at least a group-specific part of a data structure can be maintained and whenever a new value of a measurement observable becomes available for that cell reporting groupalong with a new packet of the stream arriving, the value can be recorded in the group-specific data structure or the group-specific part of the data structure. For instance, an array dimension of an array data structure can resolve between the different cell reporting group. It would also be possible to maintain, for each cell reporting group of the cell reporting groupof the battery, a respective array data structure and append new values to the appropriate array data structure, depending on the associated cell reporting group.

As a general rule, the group-specific aggregated information can pertain to the values of the one or more measurement observables that are reported. Alternatively or additionally, the group-specific aggregated information can pertain to processed information obtained from the values of the one or more measurement observables. To give a concrete example, it would be possible that the group-specific aggregated information pertains to voltage values or current values or temperature values as examples of measurement observables that are reported by the battery management system. It would also be possible that, based on the voltage and the current, a DC resistance value is calculated for each sampling time and then the group-specific DC resistance values are retained as group-specific aggregated information.

Next, at box 3030, a comparison of group-specific aggregated information is optionally executed. This comparison is between the group-specific aggregated information retained for different cell reporting group. By performing such a comparison, and anomalous behavior of one or more cells of a given cell reporting group can be identified. Since each cell reporting group only includes a comparatively small number of battery cells (e.g., less than 20), the root cause for such anomalous behavior can be tracked down to cell level, strongly limiting the number of candidate cells that cause the anomalous behavior. For instance, an outlier can be identified. For instance, it would be possible to identify that the voltage values of a certain cell reporting group deviate significantly and persistently from the voltage values of all other cell reporting group s. This would then identify this cell reporting group as having anomalous behavior. Similarly, DC resistance values could be compared.

Such approach has the benefit that at a comparatively early stage of the processing anomalous behavior of one or more cells of one or more cell reporting groups can be identified. This is further supported by a reporting scheme that reports extreme values of one or more measurement observables. Typically, such minimum and maximum values can be helpful to identify outliers.

For example, a reporting scheme may pertain to reporting the maximum value of voltage is measured for all voltage-reporting cell reporting groups of the battery. It would then be possible to identify that the repetition rate of a given cell reporting group being included in the data packet - i.e., the given cell reporting grouphas the maximum voltage value across all voltage-reporting cell reporting groups comparatively often - is larger than the repetition rate of other cell reporting groups being included in the data packets of the data stream. Based on such comparison of the repetition rate it is then possible to identify the anomalous behavior of cells in that cell reporting group.

At box 3035, it can be optionally determined whether the reporting scheme needs to be reconfigured, i.e., whether in adjusted/new setting of the reporting scheme is to be activated. Various options are available for implementing box 3035; in other words, various decision criteria are conceivable for implementing box 3035.

One example decision criterion to be considered at box 3035 would be whether an anomalous behavior has been detected at box 3030. In other words, it would be possible to reconfigure the battery management system with an updated setting of the reporting scheme for providing the stream of data packets responsive to identifying the anomalous behavior. For instance, if an anomalous behavior is detected, it is oftentimes desirable to increase the resolution of the condition monitoring. For this purpose, the information content of the data packets and/or the repetition rate with which data packets are provided can be increased (i.e., the sampling offset between adjacent sampling times can be decreased, thereby increasing the temporal resolution). For instance, values of one or more measurement observables may be provided for a larger number of cell reporting groups per data packet. I.e., the information depth per data packet can be increased. For instance, additional measurement observables may be reported. For instance, the sampling times can be closer spaced so that a higher temporal resolution can be achieved. For instance, cell reporting groups that include a smaller number of battery cells can be activated. For instance, in a first iteration, comparably large cell reporting groups may be used, e.g., each including 20 or so cells. Then, responsive to detecting anomalous behavior, in a subsequent, second iteration smaller cell reporting groups can be activated; these more cell reporting groups include fewer cells, e.g., 4 to 10 cells. Then, more cell reporting groups are defined across all battery cells of the battery, so that the reporting granularity is finer. For instance, additional observables can be reported. For example, initially, current can be reported. Once anomalous behaviors detected, voltage can be reported in addition to current. For example, current is typically reported for correspondingly large current-reporting cell reporting groups, e.g., including 10 to 20 or even more cells. On the other hand, voltage is typically reported for correspondingly small voltage-reporting voltage reporting groups, e.g., only including two to five cells. More generally, re-configuring the battery management system with the updated setting of the reporting scheme responsive to detecting the anomalous behavior at box 3030 can result in an increased data rate of the stream of data packets (due to the higher information content and/or the higher temporal resolution). By increasing the available information, more information regarding the behavior of the various cell reporting groups of the battery can be collected. This can enable to detect whether further cell reporting groups are affected by the anomalous behavior. This can enable to detect a root cause of the anomalous behavior. For instance, cell clusters affected, e.g., by a defective cooling system may be identified. For instance, cell clusters affected by a defective electrical contact can be identified. As will be appreciated, such techniques pertain to on-demand extended reporting. Triggered by the anomalous behavior, more data can be collected and condition monitoring can be extended. This, on the one hand, limits the overall data collected across an ensemble of batteries; on the other hand, when needed, additional information is made available.

Yet another example of a decision criterion to be considered at box 3035 would be to determine whether the group-specific aggregated information determined for each one of the one or more cell reporting groups fulfills one or more criteria. For instance, a minimum count of sampling times required for each one of the cell reporting groups for which the group-specific aggregated information can be checked. In other words, it could be checked whether a minimum number of data packets (per time unit) includes one or more values of one or more measurement observables for any given cell reporting group. If this is not the case, then the reporting scheme may be adjusted so that such information can be collected (e.g., by increasing the information depth per data packet). Also, an imbalance of counts of sampling times for which the group-specific aggregated information is determined for the different cells could be checked. In other words, it could be determined whether significantly more data packets are associated with a certain cell than with other cells. Alternatively or additionally, a criterion specifies the maximum time span between an earliest and the latest sampling time for which the group-specific aggregated information is determined for any given one of the one or more cell reporting groups. Thus, if for a given cell reporting groupvalues of one or more measurement observables are not obtained for a certain time duration (i.e., no reporting for this cell reporting groupavailable), then this time span is exceeded and the setting of the reporting scheme is adjusted. Such criteria as outlined above are indicators for lack of information on certain cell reporting groups of the battery. Such decision criteria can be used to ensure that sufficient group-specific aggregated information is available for any cell reporting group.

Another decision criterion for box 3035 includes a predetermined timing schedule. For instance, it would be possible that the reporting scheme is reconfigured in between two settings from time to time. For instance, for any given battery, the normal state can be a reporting with limited information depth; from time to time, e.g., after so and so many operational hours of the respective battery or another timing schedule, the information depth can be temporarily increased by updating the setting of the reporting scheme for a certain duration. This allows to collect additional information for an extended condition monitoring.

At box 3040, the cell state of one or more cells of the battery is assessed. This is based on the group-specific aggregated information for each cell reporting group, as determined in box 3025. Cell states can be collectively determined for all cells of cell reporting groups.

For instance, an averaged DC resistance of all cells of a given cell reporting group could be determined based on individual DC resistance values calculated as group-specific aggregated information for the given cell reporting group at multiple sampling times. More complex evaluation algorithms can be employed. For instance, data-driven models, e.g., deep neural networks, can be employed to determine a state of health.

The arrangement of boxes in FIG. 5 is only one example. For instance, it would be possible that box 3040 is executed prior to box 3030. It would also be possible that box 3040 is integrated into box 3025. I.e., the cell state can be directly associated with the aggregated information.

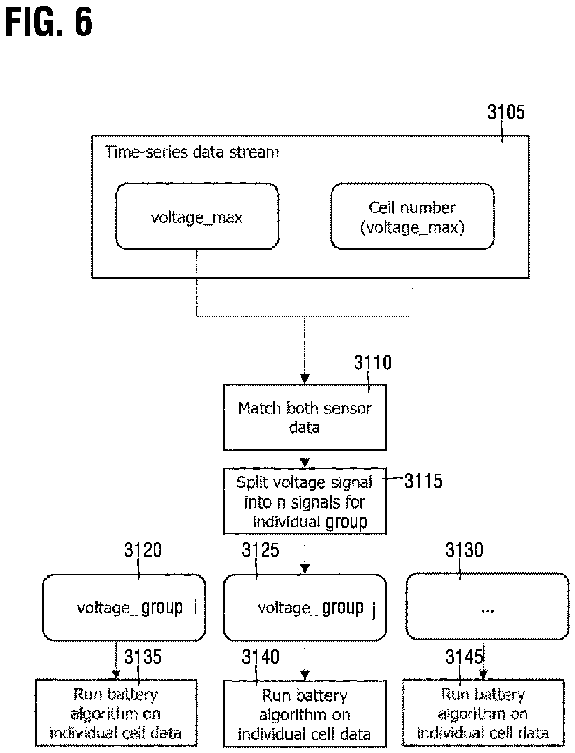

FIG. 6 schematically illustrates a processing pipeline used for assessing a cell state of multiple cells of a battery. For instance, the processing pipeline of FIG. 6 can implement the method of FIG. 5.

At box 3105, a data stream is obtained from a battery management system (cf. box 3020 of the method of FIG. 5). The data stream includes multiple data packets in a respective sequence. Each data packet indicates the maximum voltage value at a given sampling time observed across all voltage-reporting cell reporting groups. Also, the cell reporting group identity of the particular cell reporting group that experienced the maximum voltage value at the given sampling time is indicated.

Then, cell reporting group number and maximum voltage number are retained in a respective data structure at box 3110, associated with that given sampling interval.

The data structure is then analyzed at box 3115 and separated into individual voltage values obtained for different cell reporting group s (cf. box 3025 of FIG. 5). These voltage values are collected in respective data structures associated with each individual cell reporting group, corresponding to box 3120, box 3125, and box 3130. I.e., the data stream is analyzed to separate values of a measurement observable - here, the voltage - associated with different cell reporting group s.

Then, at box 3135, based on respective group-specific aggregated information according to box 3120, box 3125, and box 3130, the cell state is assessed using a respective evaluation algorithm. For instance, the DC resistance can be calculated for each cell of the respective cell reporting group (cf. box 3040 of FIG. 5).

Summarizing, techniques have been disclosed that facilitate splitting a time series of signals of maximum- and minimum-aggregation of sensors of a battery management system into piecewise defined signals which then represent individual cell reporting group s (cf. FIG. 4). This can be done for different sensor types, e.g., voltage and/or current and/or temperature and/or pressure. Algorithms can then run on these new cell-based sensors to calculate battery parameters for cells or small groups of cells. Examples include the DC resistance calculation. This makes individual cells or small groups of cells observable from only aggregated signals.

Further summarizing, the following EXAMPLES have been disclosed.
EXAMPLE 1.A computer-implemented method, the method comprising:
   - obtaining a stream (200) of data packets (211-214) from a battery management system (151) of a battery (150) that comprises a plurality of cell reporting groups (881, 882, 883, 884, 890), each data packet (211-214) of the stream (200) of data packets (211-214) being associated with a subset of cell reporting groups of the plurality of cell reporting groups (881, 882, 883, 884, 890), each cell reporting group (881, 882, 883, 884, 890) comprising one or more battery cells (159, 811-814, 821 - 824, 831-834, 841-844) of the battery, each data packet (211-214) comprising values (301-303) of at least one measurement observable (330) for each cell reporting group (881, 882, 883, 884, 890) of the respective subset and at a respective sampling time, and
   - analyzing the stream (200) of data packets (211-214) to determine, for each one of one or more cell reporting groups (881, 882, 883, 884, 890) of the plurality of cell reporting groups (881, 882, 883, 884, 890), respective group-specific aggregated information across multiple sampling times based on the values of the at least one measurement observable (330) provided for the respective cell reporting group, and
   - for each one of the one or more cell reporting groups (881, 882, 883, 884, 890) of the plurality of cell reporting groups (881, 882, 883, 884, 890): assessing a cell state of the respective one or more battery cells (159, 811-814, 821-824, 831-834, 841-844) based on the respective group-specific aggregated information.
EXAMPLE 2. The computer-implemented method of EXAMPLE 1,
   wherein said assessing of the cell state comprises performing a comparison of the group-specific aggregated information between the one or more of cell reporting groups (881, 882, 883, 884, 890) of the plurality of cell reporting groups (881, 882, 883, 884, 890) and identifying an anomalous behavior of a given cell reporting group (881, 882, 883, 884, 890) based on the comparison.
EXAMPLE 3. The computer-implemented method of EXAMPLE 1 or 2, further comprising:
   - for each one of the one or more cell reporting groups (881, 882, 883, 884, 890) of the plurality of cell reporting groups (881, 882, 883, 884, 890): determining a respective repetition rate with which data packets (211-214) that are associated with subsets that include the respective cell reporting group (881, 882, 883, 884, 890) appear in the stream (200),
   - performing a comparison of the repetition rates, and
   - identifying an anomalous behavior of one or more battery cells (159, 811-814, 821-824, 831-834, 841-844) of a given cell reporting group (881, 882, 883, 884, 890) of the plurality of cell reporting groups (881, 882, 883, 884, 890) based on the comparison.
EXAMPLE 4. The computer-implemented method of any one of the preceding EXAMPLEs, further comprising:
   - based on the group-specific aggregated information: identifying an anomalous behavior of one or more battery cells (159, 811-814, 821-824, 831-834, 841 - 844) of a given cell reporting group (881, 882, 883, 884, 890) of the plurality of cell reporting groups (881, 882, 883, 884, 890), and
   - responsive to identifying the anomalous behavior: re-configuring the battery management system (151) with an updated setting of a reporting scheme for providing the stream (200) of data packets (211-214).
EXAMPLE 5. The computer-implemented method of EXAMPLE 4,
   wherein re-configuring of the battery management system (151) with the updated setting of the reporting scheme results in an increased data rate of the stream (200) of data packets (211-214).
EXAMPLE 6. The computer-implemented method of EXAMPLE 4 or 5,
   wherein the updated setting comprises additional cell reporting groups and/or additional measurement observables.
EXAMPLE 7. The computer-implemented method of EXAMPLE 5 or 6,
   wherein the updated setting has a higher temporal resolution.
EXAMPLE 8. The computer-implemented method of any one of the preceding EXAMPLEs,
   wherein the stream (200) of data packets (211-214) is provided in accordance with a current setting of a reporting scheme,
   wherein the reporting scheme defines a sampling offset between adjacent sampling times.
EXAMPLE 9. The computer-implemented method of any one of the preceding EXAMPLEs,
   wherein the stream (200) of data packets (211-214) is provided in accordance with a current setting of a reporting scheme,
   wherein the reporting scheme defines an information content of the data packets (211-214) of the stream (200).
EXAMPLE 10. The computer-implemented method of EXAMPLE 9,
   wherein the information content comprises an integer value *n,*
   wherein each subset of cell reporting groups (881, 882, 883, 884, 890) is selected so that the associated data packet (211-214) comprises the n largest or *n* smallest values of the at least one measurement observable (330) across all cell reporting groups (881, 882, 883, 884, 890) of the plurality of cell reporting groups at the respective sampling time.
EXAMPLE 11. The computer-implemented method of EXAMPLE 9 or 10,
   wherein the information content comprises the at least one measurement observable (330).
EXAMPLE 12. The computer-implemented method of any one of the preceding EXAMPLEs,
   wherein the stream (200) of data packets (211-214) is provided in accordance with a current setting of a reporting scheme,
   wherein the reporting scheme specifies even-triggered reporting or repetitive reporting of the data packets (211-214).
EXAMPLE 13. The computer-implemented method of any one of the preceding EXAMPLEs, further comprising:
   - determining whether the group-specific aggregated information determined for each one of the one or more cell reporting groups (881, 882, 883, 884, 890) fulfills one or more criteria, and
   - depending on whether the group-specific aggregated information determined for each one of the one or more cell reporting groups (881, 882, 883, 884, 890) fulfills the one or more criteria, re-configuring the battery management system (151) with an updated setting of a reporting scheme for providing the stream (200) of data packets (211-214).
EXAMPLE 14. The computer-implemented method of EXAMPLE 13,
   wherein the one or more criteria specify a minimum count of the sampling times required for each one of the one or more cell reporting groups of the plurality of cell reporting groups for which the group-specific aggregated information is determined.
EXAMPLE 15. The computer-implemented method of EXAMPLE 13 or 14,
   wherein the one or more criteria specify a maximum imbalance of counts of the sampling times for which the group-specific aggregated information is determined for the one or more cell reporting groups of the plurality of cell reporting groups.
EXAMPLE 16. The computer-implemented method of any one of EXAMPLEs 13 to 15,
   wherein the one or more criteria specify a maximum time span between an earliest and a latest sampling time for which the group-specific aggregated information is determined for any given one of the one or more cell reporting groups (881, 882, 883, 884, 890) of the plurality of cell reporting groups (881, 882, 883, 884, 890).
EXAMPLE 17. The computer-implemented method of any one of the preceding EXAMPLEs, further comprising:
   - establishing a data connection with the battery management system (151) via the Internet,
   wherein the stream (200) of data packets (211-214) is received via the data connection.
EXAMPLE 18. The computer-implemented method of EXAMPLE 17,
   wherein the data connection is established responsive to a registration of the battery management system (151) at a repository,
   the registration being indicative of a type of the battery management system (151).
EXAMPLE 19. The computer-implemented method of EXAMPLE 18,
   - responsive to establishing the data connection: configuring the battery management system with a setting of a reporting scheme for providing the stream (200) of data packets (211-214), the setting being selected based on the type of the battery management system.
EXAMPLE 20. A computing device comprising a processor and a memory, the processor being configured to load program code from the memory and to execute the program code, the processor, upon executing the program code, performing the method of any one of the preceding EXAMPLEs.

Although the invention has been shown and described with respect to certain preferred embodiments, equivalents and modifications will occur to others skilled in the art upon the reading and understanding of the specification. The present invention includes all such equivalents and modifications and is limited only by the scope of the appended claims.

For illustration, while above scenarios have been disclosed in which cell reporting groups have a comparably include a comparatively small count of cells, and further scenario cell reporting groups can also include a larger count of battery cells, e.g., more than 20 or more than 100 battery cells, etc.

## Claims

1. A computer-implemented method, the method comprising:
- obtaining a stream (200) of data packets (211-214) from a battery management system (151) of a battery (150) that comprises a plurality of cell reporting groups (881, 882, 883, 884, 890), each data packet (211-214) of the stream (200) of data packets (211-214) being associated with a subset of cell reporting groups of the plurality of cell reporting groups (881, 882, 883, 884, 890), each cell reporting group (881, 882, 883, 884, 890) comprising one or more battery cells (159, 811-814, 821 - 824, 831-834, 841-844) of the battery, each data packet (211-214) comprising values (301-303) of at least one measurement observable (330) for each cell reporting group (881, 882, 883, 884, 890) of the respective subset and at a respective sampling time, and
- analyzing the stream (200) of data packets (211-214) to determine, for each one of one or more cell reporting groups (881, 882, 883, 884, 890) of the plurality of cell reporting groups (881, 882, 883, 884, 890), respective group-specific aggregated information across multiple sampling times based on the values of the at least one measurement observable (330) provided for the respective cell reporting group, and
- for each one of the one or more cell reporting groups (881, 882, 883, 884, 890) of the plurality of cell reporting groups (881, 882, 883, 884, 890): assessing a cell state of the respective one or more battery cells (159, 811-814, 821-824, 831-834, 841-844) based on the respective group-specific aggregated information.

2. The computer-implemented method of claim 1,
wherein said assessing of the cell state comprises performing a comparison of the group-specific aggregated information between the one or more of cell reporting groups (881, 882, 883, 884, 890) of the plurality of cell reporting groups (881, 882, 883, 884, 890) and identifying an anomalous behavior of a given cell reporting group (881, 882, 883, 884, 890) based on the comparison.

3. The computer-implemented method of claim 1 or 2, further comprising:
- for each one of the one or more cell reporting groups (881, 882, 883, 884, 890) of the plurality of cell reporting groups (881, 882, 883, 884, 890): determining a respective repetition rate with which data packets (211-214) that are associated with subsets that include the respective cell reporting group (881, 882, 883, 884, 890) appear in the stream (200),
- performing a comparison of the repetition rates, and
- identifying an anomalous behavior of one or more battery cells (159, 811-814, 821-824, 831-834, 841-844) of a given cell reporting group (881, 882, 883, 884, 890) of the plurality of cell reporting groups (881, 882, 883, 884, 890) based on the comparison.

4. The computer-implemented method of any one of the preceding claims, further comprising:
- based on the group-specific aggregated information: identifying an anomalous behavior of one or more battery cells (159, 811-814, 821-824, 831-834, 841 - 844) of a given cell reporting group (881, 882, 883, 884, 890) of the plurality of cell reporting groups (881, 882, 883, 884, 890), and
- responsive to identifying the anomalous behavior: re-configuring the battery management system (151) with an updated setting of a reporting scheme for providing the stream (200) of data packets (211-214).

5. The computer-implemented method of claim 4,
wherein re-configuring of the battery management system (151) with the updated setting of the reporting scheme results in an increased data rate of the stream (200) of data packets (211-214).

6. The computer-implemented method of claim 4 or 5,
wherein the updated setting comprises additional cell reporting groups and/or additional measurement observables and/or has a higher temporal resolution.

7. The computer-implemented method of any one of the preceding claims,
wherein the stream (200) of data packets (211-214) is provided in accordance with a current setting of a reporting scheme,
wherein the reporting scheme defines a sampling offset between adjacent sampling times.

8. The computer-implemented method of any one of the preceding claims,
wherein the stream (200) of data packets (211-214) is provided in accordance with a current setting of a reporting scheme,
wherein the reporting scheme defines an information content of the data packets (211-214) of the stream (200).

9. The computer-implemented method of claim 8,
wherein the information content comprises an integer value *n,*
wherein each subset of cell reporting groups (881, 882, 883, 884, 890) is selected so that the associated data packet (211-214) comprises the n largest or *n* smallest values of the at least one measurement observable (330) across all cell reporting groups (881, 882, 883, 884, 890) of the plurality of cell reporting groups at the respective sampling time.

10. The computer-implemented method of claim 8 or 9,
wherein the information content comprises the at least one measurement observable (330).

11. The computer-implemented method of any one of the preceding claims,
wherein the stream (200) of data packets (211-214) is provided in accordance with a current setting of a reporting scheme,
wherein the reporting scheme specifies even-triggered reporting or repetitive reporting of the data packets (211-214).

12. The computer-implemented method of any one of the preceding claims, further comprising:
- determining whether the group-specific aggregated information determined for each one of the one or more cell reporting groups (881, 882, 883, 884, 890) fulfills one or more criteria, and
- depending on whether the group-specific aggregated information determined for each one of the one or more cell reporting groups (881, 882, 883, 884, 890) fulfills the one or more criteria, re-configuring the battery management system (151) with an updated setting of a reporting scheme for providing the stream (200) of data packets (211-214).

13. The computer-implemented method of claim 13,
wherein the one or more criteria specify a minimum count of the sampling times required for each one of the one or more cell reporting groups of the plurality of cell reporting groups for which the group-specific aggregated information is determined.

14. The computer-implemented method of claim 12 or 13,
wherein the one or more criteria specify a maximum imbalance of counts of the sampling times for which the group-specific aggregated information is determined for the one or more cell reporting groups of the plurality of cell reporting groups.

15. The computer-implemented method of any one of claims 12 to 14,
wherein the one or more criteria specify a maximum time span between an earliest and a latest sampling time for which the group-specific aggregated information is determined for any given one of the one or more cell reporting groups (881, 882, 883, 884, 890) of the plurality of cell reporting groups (881, 882, 883, 884, 890).
